# EUROPEAN PATENT APPLICATION

(11) **EP 4 633 310 A1**
(43) Date of publication of application: **15.10.2025**
(21) Application number: 25163733.6
(22) Date of filing: 14.03.2025
(51) Int. Cl.: H05K 7/20

(54) **DOMAIN CONTROLLER AND MOBILE PLATFORM**

(30) Priority: 29.03.2024 CN 202420643191 U
(71) Applicant: SZ Zhuoyu Technology Co., Ltd., Shenzhen, Guangdong 518057 (CN)
(72) Inventor: ZOU, Run, Shenzhen (CN); CHEN, Kai, Shenzhen (CN)
(74) Representative: Bandpay & Greuter

(57) **Abstract**

The present application provides a domain controller and a mobile platform. The domain controller includes a housing, where a heat dissipation assembly and a circuit board are stacked inside the housing, a side of the circuit board facing the heat dissipation assembly is provided with a first chip, the heat dissipation assembly is provided with a first heat dissipation boss, a side of the heat dissipation assembly facing away from the circuit board is further provided with an elastic member in a compressed state, where a first end of the elastic member abuts against the housing and a second end of the elastic member abuts against the heat dissipation assembly, enabling the first heat dissipation boss to abut against the first chip, and the housing is provided with a supporting portion and the supporting portion abuts against the circuit board. In the present application, the elastic member in the compressed state is provided at the side of the heat dissipation assembly facing away from the circuit board, so that the first heat dissipation boss tightly abuts against the first chip with a reduced distance between the first heat dissipation boss and the first chip. The corresponding supporting portion is provided on the housing to support the circuit board, thereby reducing the stress borne by the circuit board and reducing the risk of cracking of the first chip.

## Description

### TECHNICAL FIELD

The present application relates to the field of chip assembling technologies and, in particular, to a domain controller and a mobile platform.

### BACKGROUND

A domain controller is a critical network server configured to manage and control computers, users, and resources within a domain. In the field of vehicles, the domain controller is responsible for managing and controlling various functions of the vehicles, including but not limited to powertrain, chassis control, and information processing of intelligent cabins.

Since the domain controller needs to process a large amount of information, the heat dissipation performance of the domain controller directly influences the information processing capability thereof. In the relevant technical solutions, in order to improve the heat dissipation performance of the domain controller, a gap between a heat sink and a chip can be compressed to reduce the thickness of a thermal conductive layer between the chip and the heat sink, trying to guide the heat of the chip into the heat sink as soon as possible. However, the stress borne by the chip and the circuit board is increased by adopting the above solution, which poses a risk of chip cracking.

### SUMMARY

In order to overcome the above-mentioned deficiencies in the related art, the objective of the present application is to provide a domain controller and a mobile platform. The present application can reduce the stress borne by a chip and a circuit board while reducing a gap between the chip and a heat sink, to reduce the risk of chip cracking.

In an aspect, the present application provides a domain controller, including a housing, where a heat dissipation assembly and a circuit board are stacked inside the housing, a side of the circuit board facing the heat dissipation assembly is provided with a first chip, the heat dissipation assembly is provided with a first heat dissipation boss, a side of the heat dissipation assembly facing away from the circuit board is further provided with an elastic member in a compressed state, where a first end of the elastic member abuts against the housing and a second end of the elastic member abuts against the heat dissipation assembly, enabling the first heat dissipation boss to abut against the first chip, and the housing is provided with a supporting portion and the supporting portion abuts against the circuit board.

In a possible implementation, the elastic member includes a spring, the housing is provided with a mounting groove, and the spring is provided in the mounting groove.

In a possible implementation, the elastic member includes a sealing ring or a resilient pad, and the elastic member is provided along a circumferential direction of the heat dissipation assembly.

In a possible implementation, the housing includes a bottom cover and an upper housing, the circuit board is provided close to the bottom cover, the supporting portion is provided on the bottom cover, and the bottom cover, the upper housing and the circuit board are connected through a first fastener, to compress the elastic member between the upper housing and the heat dissipation assembly.

In a possible implementation, a projection of the first chip is located within a projection range of the supporting portion in a plane parallel to the circuit board.

In a possible implementation, the side of the circuit board facing the heat dissipation assembly is further provided with a plurality of second chips, the plurality of second chips are provided around the first chip, the heat dissipation assembly is further provided with a plurality of second heat dissipation bosses, and the plurality of second heat dissipation bosses are in one-to-one correspondence with the plurality of second chips.

In a possible implementation, a first thermal conductive layer is filled between the first heat dissipation boss and the first chip, a second thermal conductive layer is filled between the second heat dissipation boss and the second chip, and a thickness of the second thermal conductive layer is greater than a thickness of the first thermal conductive layer.

In a possible implementation, the heat dissipation assembly includes a vapor chamber and a heat dissipation assembly main body, where the vapor chamber is provided on a side of the heat dissipation assembly main body facing the circuit board, and the first heat dissipation boss and the plurality of second heat dissipation bosses are all provided on the vapor chamber.

In a possible implementation, the heat dissipation assembly main body is provided with a plurality of limiting holes, the upper housing is provided with a plurality of limiting posts, the plurality of limiting posts are in one-to-one correspondence with the plurality of limiting holes, and the limiting posts are inserted into the corresponding limiting holes.

In another aspect, the present application provides a mobile platform, including a domain controller as described above.

The present application provides a domain controller and a mobile platform. The domain controller includes a housing, where a heat dissipation assembly and a circuit board are stacked inside the housing, a side of the circuit board facing the heat dissipation assembly is provided with a first chip, the heat dissipation assembly is provided with a first heat dissipation boss, a side of the heat dissipation assembly facing away from the circuit board is further provided with an elastic member in a compressed state, where a first end of the elastic member abuts against the housing and a second end of the elastic member abuts against the heat dissipation assembly, enabling the first heat dissipation boss to abut against the first chip, and the housing is provided with a supporting portion and the supporting portion abuts against the circuit board. In the present application, the elastic member in the compressed state is provided at the side of the heat dissipation assembly facing away from the circuit board, so that the first heat dissipation boss tightly abuts against a first chip with a reduced distance between the first heat dissipation boss and the first chip. The corresponding supporting portion is provided on the housing to support the circuit board, thereby reducing the stress borne by the circuit board and reducing the risk of cracking of the first chip.

### BRIEF DESCRIPTION OF THE DRAWINGS

In order to illustrate the technical solutions in the embodiments of the present application or in the related art more clearly, a brief description will be given to the accompanying drawings required for the description of the embodiments or the related art. Obviously, the accompanying drawings in the following description are merely some embodiments of the present application, and for those ordinarily skilled in the art, other drawings can also be obtained from these drawings without creative efforts.
FIG. 1 is an exploded view of a domain controller according to an embodiment of the present application.
FIG. 2 is a cross-sectional view of a domain controller according to an embodiment of the present application.
FIG. 3 is another cross-sectional view of a domain controller according to an embodiment of the present application.
FIG. 4 is a simplified structure diagram of an upper housing from a first perspective according to an embodiment of the present application.
FIG. 5 is a simplified structure diagram of an upper housing from a second perspective according to an embodiment of the present application.
FIG. 6 is a partial structural diagram of a heat dissipation assembly according to an embodiment of the present application.
FIG. 7 is a simplified structure diagram of a circuit board according to an embodiment of the present application.
FIG. 8 is a simplified structure diagram of a bottom cover according to an embodiment of the present application.

Reference numerals:
110-upper housing; 111-mounting groove; 112-limiting post; 113-heat dissipation through hole; 114-second threaded hole; 115- thermal conductive adhesive groove; 116-fan fixing structure; 120-bottom cover; 121-supporting portion; 122-first threaded hole;
200-heat dissipation assembly; 210-vapor chamber; 211-first heat dissipation boss; 212-second heat dissipation boss; 220-heat dissipation assembly main body; 221-limiting hole; 230- heat dissipation fin; 240-fan; 250-fan cover;
300-circuit board; 310-first chip; 320-second chip; 330-through hole;
400-elastic member;
500-first fastener;
610-first thermal conductive layer; 620-second thermal conductive layer;
700- thermal conductive adhesive layer;
800-second fastener.

### DESCRIPTION OF EMBODIMENTS

In order to make the objectives, technical solutions, and advantages of the embodiments in the present application clearer, the technical solutions in the embodiments of the present application is hereinafter clearly and completely described with reference to the accompanying drawings of the embodiments of the present application. Obviously, the described embodiments are merely some rather than all of the embodiments of the present application.

Based on the embodiments of the present application, all other embodiments obtained by those ordinarily skilled in the art without creative efforts shall fall within the protection scope of the present application. In non-conflicting situations, the following embodiments and features in the embodiments may be combined with each other.

As described in the background, in the relevant technical solutions, the thickness of the thermal conductive layer filled between the chip and the heat sink is reduced in order to reduce the gap between the heat sink and the chip, so that the circuit board and the chip are subjected to greater stress. For example, in some solutions, a spring may be provided on a side of the heat sink facing away from the chip, and an elastic force of the spring is utilized to press the heat sink against the chip. However, this solution ultimately transfers pressure to the circuit board and poses a risk of chip cracking.

In view of this, the embodiments of the present application aim to provide a domain controller and a mobile platform, where an elastic member in a compressed state is provided at a side of a heat dissipation assembly facing away from a circuit board, so that a first heat dissipation boss tightly abuts against a first chip with a reduced distance between the first heat dissipation boss and the first chip. The corresponding supporting portion is provided on the housing to support the circuit board, thereby reducing the stress borne by the circuit board and reducing the risk of cracking of the first chip.

The content of the embodiments in the present application will be described in detail below with reference to the accompanying drawings, so that those skilled in the art can understand the content of the present application in more detail.

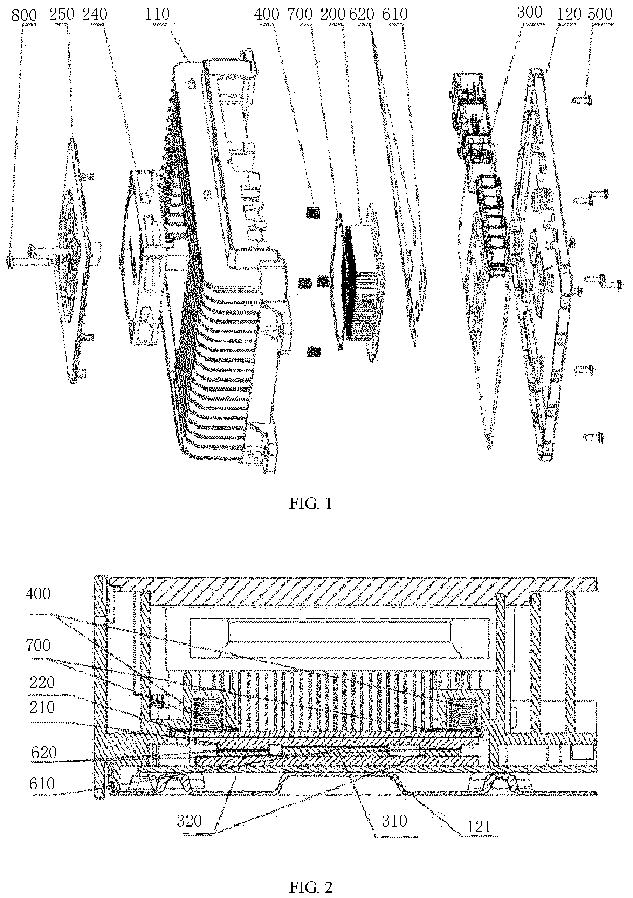

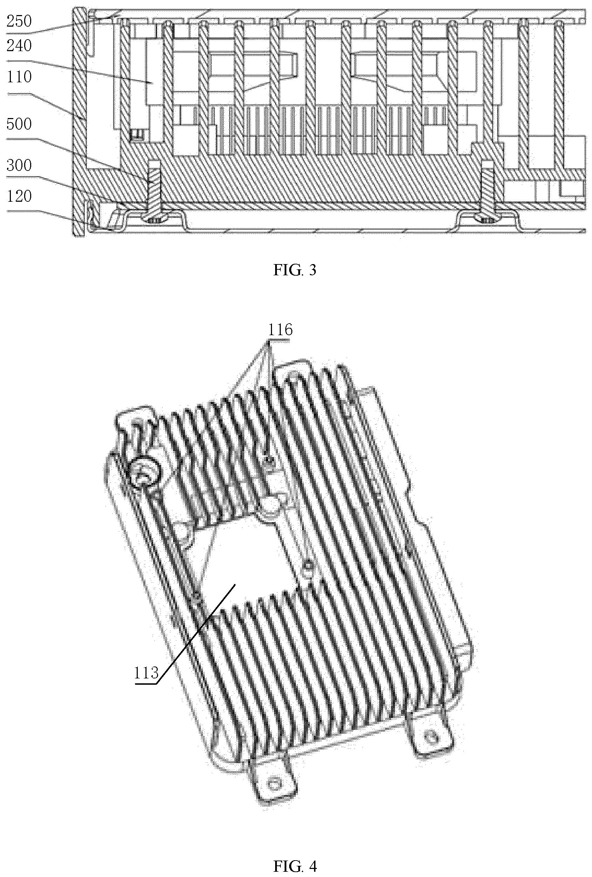

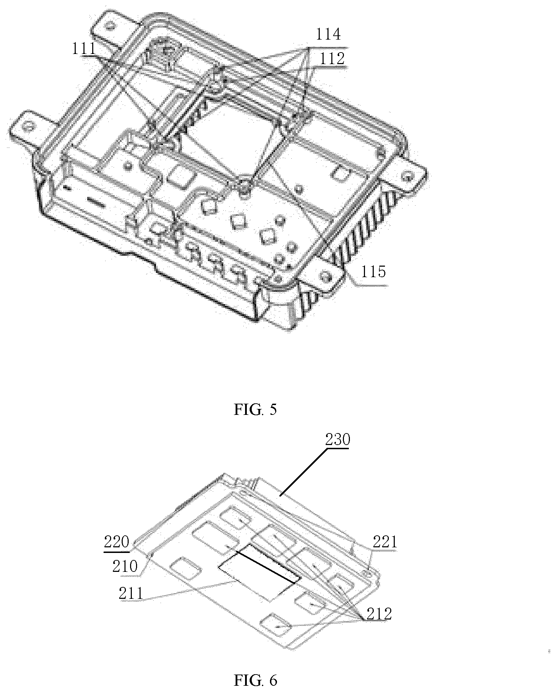

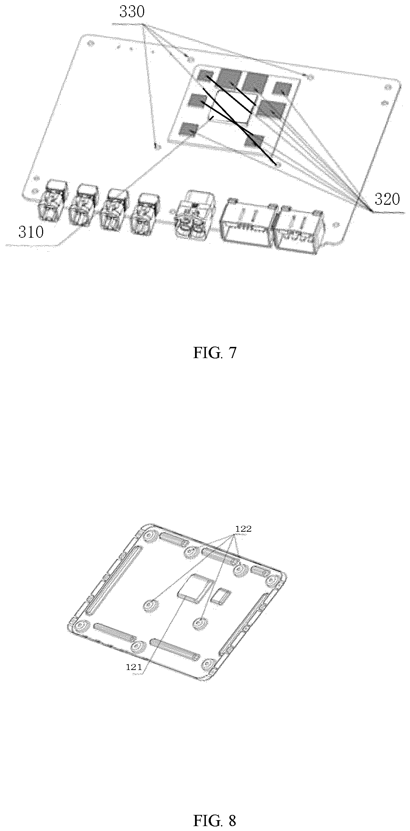

FIG. 1 is an exploded view of a domain controller according to an embodiment of the present application, FIG. 2 is a cross-sectional view of a domain controller according to an embodiment of the present application, FIG. 3 is another cross-sectional view of a domain controller according to an embodiment of the present application, FIG. 4 is a simplified structure diagram of an upper housing from a first perspective according to an embodiment of the present application, FIG. 5 is a simplified structure diagram of an upper housing from a second perspective according to an embodiment of the present application, FIG. 6 is a partial structural diagram of a heat dissipation assembly according to an embodiment of the present application, FIG. 7 is a simplified structure diagram of a circuit board according to an embodiment of the present application, and FIG. 8 is a simplified structure diagram of a bottom cover according to an embodiment of the present application.

Please refer to FIGs. 1-8, the embodiments of the present application provide a domain controller, which includes a housing. The shape of the housing may be configured according to assembly needs, which for example, may be prismatic or cylindrical. The housing may include, for example, a bottom cover 120 and an upper housing 110, and the upper housing 110 and the bottom cover 120 may be assembled into the housing. A heat dissipation assembly 200 and a circuit board 300 are stacked inside the housing, the circuit board 300 is provided close to the bottom cover 120, and the heat dissipation assembly 200 is configured to export the heat generated by the circuit board 300 during operation, thereby ensuring the information processing capability of the domain controller.

Specifically, a first chip 310 is provided on a side of the circuit board 300 facing the heat dissipation assembly 200, and the first chip 310 is a main chip responsible for main information processing work, so that the heat generated thereby is also relatively large. The heat dissipation assembly 200 is provided with a first heat dissipation boss 211, and a side of the heat dissipation assembly 200 facing away from the circuit board 300 is further provided with an elastic member 400 in a compressed state, where a first end of the elastic member 400 abuts against the housing and a second end of the elastic member 400 abuts against the heat dissipation assembly 200, so that an elastic force of the elastic member 400 is utilized to press the first heat dissipation boss 211 against the first chip 310, to reduce the gap between the first heat dissipation boss 211 and the first chip 310, thereby improving the heat dissipation speed of the first chip 310. In the embodiments of the present application, a compression range of the elastic member 400 is designed such that it covers a sum of a height tolerance fluctuation of the first chip 310, a manufacturing tolerance during an assembly process of the upper housing 110 with the circuit board 300, and a manufacturing tolerance of the first heat dissipation boss 211, to ensure that the gap between the first heat dissipation boss 211 and the first chip 310 after the assembly is as small as possible.

In the embodiments of the present application, the housing is provided with a supporting portion 121, the supporting portion 121 is provided on the bottom cover 120, and the supporting portion 121 abuts against the circuit board 300. It may be understood that the first chip 310 is provided on a first side of the circuit board 300, and the supporting portion 121 abuts against a second side of the circuit board 300 opposite to the first side, so that the supporting portion 121 can provide a supporting force to the circuit board 300, to reduce the pressure applied by the elastic member 400 on the circuit board 300 and reduce the risk of cracking of the first chip 310. Alternatively, it may be understood that, the pressure applied by the elastic member 400 is finally transferred to the bottom cover 120 by providing the supporting portion 121, thereby reducing the stress borne by the circuit board 300 and preventing the first chip 310 from cracking caused by bending of the circuit board 300.

Optionally, in the embodiments of the present application, the supporting portion 121 includes a protrusion provided on the bottom cover 120. In a plane parallel to the circuit board 300, a projection of the first chip 310 is located within a projection range of the supporting portion 121, so that the projection area of the supporting portion 121 completely covers the projection area of the first chip 310, to provide a stable supporting force for the first chip 310.

In other possible implementations, the supporting portion 121 includes a steel reinforcing structure, such as a rib, provided on the bottom cover 120, and a plurality of ribs provided at intervals may be provided on the bottom cover 120, so that the plurality of ribs are configured to provide a stable supporting force for the first chip 310.

In a possible implementation, the elastic member 400 according to the embodiments of the present application includes a spring, the housing is provided with a mounting groove 111, and the spring is provided in the mounting groove 111, so that the mounting groove can be configured to apply circumferential restrictions to the spring, thereby preventing the spring from becoming unstable and falling off during installation and use.

For example, the number and positions of the springs may be determined based on the shape of the heat dissipation assembly 200 and the like. For example, a plurality of springs may be provided, and the plurality of springs are provided at intervals along a circumferential direction of the heat dissipation assembly 200, so that the heat dissipation assembly 200 can abut against the circuit board 300 in a better manner, with uniform force applied at all points. As shown in FIGs. 1, 5 and 6, in the embodiments of the present application, the heat dissipation assembly 200 is generally in the shape of a quadrangular prism, so that four springs may be provided, corresponding to four corners of the heat dissipation assembly 200 respectively. Correspondingly, four mounting grooves 111 may be provided on the upper housing 110 for installing the four springs respectively.

In another possible implementation, the elastic member 400 may also include a structure such as a sealing ring or a resilient pad. In this case, the elastic member 400 may be continuously provided in a circle along the circumferential direction of the heat dissipation assembly 200, so that the heat dissipation assembly 200 abuts against the circuit board 300.

In the embodiments of the present application, the elastic member 400 can be maintained in the compressed state through an assembly structure of the domain controller itself. For example, in the embodiments of the present application, the bottom cover 120, the upper housing 110, and the circuit board 300 are connected through a first fastener 500, to compress the elastic member 400 between the upper housing 110 and the heat dissipation assembly 200. Please refer to FIGs. 1, 3, 5, 7 and 8, in the embodiments of the present application, the bottom cover 120 is provided with a plurality of first threaded holes 122, and the first threaded holes 122 may be convex in shape, so that the first threaded holes 122 can be configured to provide partial supporting force to the circuit board 300, thereby further reducing the stress borne by the circuit board 300. The circuit board 300 is provided with a plurality of through holes 330 that are in one-to-one correspondence with the first threaded holes 122. The upper housing 110 is provided with a plurality of second threaded holes 114 corresponding to the first threaded holes 122 and the through holes 330. During assembly, the first fastener 500 sequentially passes through the first threaded hole 122, the through hole 330, and the second threaded hole 114 to connect the bottom cover 120, the upper housing 110 and the circuit board 300 as a whole and compress the elastic member 400 between the upper housing 110 and the heat dissipation assembly 200. Using the first fastener 500 to lock the circuit board 300 with the housing can also prevent the circuit board 300 from bending and deforming.

Optionally, in the embodiments of the present application, a first thermal conductive layer 610 is filled between the first heat dissipation boss 211 and the first chip 310, and the first thermal conductive layer 610 may be, for example, a thermal conductive adhesive layer, such as a thermal conductive silicone layer. It can be understood that due to the existence of the elastic member 400, the gap between the first heat dissipation boss 211 and the first chip 310 is very small (tending towards zero-gap), so that the thickness of the first thermal conductive layer 610 is very thin. By providing the first thermal conductive layer 610, a heat dissipation speed from the first chip 310 to the first heat dissipation boss 211 can be accelerated, thereby eliminating the impact of thermal resistance due to the tiny gap between the first heat dissipation boss 211 and the first chip 310.

As shown in FIGs. 1, 2, 6 and 7, in the embodiments of the present application, the side of the circuit board 300 facing the heat dissipation assembly 200 is further provided with a plurality of second chips 320, and the second chips 320 are auxiliary chips which can assist the first chip 310 in information processing. The plurality of second chips 320 may be provided around the first chip 310. The heat dissipation assembly 200 is further provided with a plurality of second heat dissipation bosses 212, and the plurality of second heat dissipation bosses 212 are in one-to-one correspondence with the plurality of second chips 320, so that the plurality of second heat dissipation bosses 212 are utilized for heat dissipation for the plurality of second chips 320.

Furthermore, a second thermal conductive layer 620 is filled between the second heat dissipation boss 212 and the second chip 320, and the second thermal conductive layer 620 may be, for example, a thermal conductive adhesive layer, such as a thermal conductive silicone layer. The second thermal conductive layer 620 may accelerate a heat dissipation speed from the second chip 320 to the second heat dissipation boss 212. Since the first chip 310 is used as a reference in the embodiments of the present application, a gap between the first heat dissipation boss 211 and the first chip 310 is first considered in design, to maintain a zero-gap state therebetween. Therefore, the gap between the second heat dissipation boss 212 and the second chip 320 is larger than the gap between the first heat dissipation boss 211 and the first chip 310, and the thickness of the second thermal conductive layer 620 is also greater than the thickness of the first thermal conductive layer 610.

As shown in FIG. 6, the heat dissipation assembly 200 in the embodiments of the present application includes a vapor chamber 210 and a heat dissipation assembly main body 220. The vapor chamber 210 is provided on a side of the heat dissipation assembly main body 220 facing the circuit board 300. The vapor chamber 210 can evenly guide the heat to various positions of the heat dissipation assembly main body 220, thereby improving the heat dissipation capability. The first heat dissipation boss 211 and the plurality of second heat dissipation bosses 212 are all provided on the vapor chamber 210.

Optionally, the vapor chamber 210 and the heat dissipation assembly main body 220 in the embodiments of the present application may be welded together, thereby forming a whole structure.

Furthermore, in the embodiments of the present application, the heat dissipation assembly main body 220 is provided with a plurality of limiting holes 221, the upper housing 110 is provided with a plurality of limiting posts 112, the plurality of limiting posts 112 are in one-to-one correspondence with the plurality of limiting holes 221, and the limiting posts 112 are inserted into the corresponding limiting holes 221, to achieve the positioning of the heat dissipation assembly 200 when being mounted.

In order to further improve the heat dissipation capability of the heat dissipation assembly 200, the heat dissipation assembly 200 in the embodiments of the present application further includes a plurality of heat dissipation fins 230, and the plurality of heat dissipation fins 230 are provided on a side of the heat dissipation assembly main body 220 facing away from the circuit board 300. The upper housing 110 is further provided with a heat dissipation through hole 113, and the plurality of heat dissipation fins 230 pass through the heat dissipation through hole 113, so that the heat of the heat dissipation assembly main body 220 can be dissipated to an external environment as soon as possible.

Furthermore, in the embodiments of the present application, a thermal conductive adhesive layer 700 is filled between the upper housing 110 and the heat dissipation assembly main body 220, and the thermal conductive adhesive layer 700 can transfer partial heat of the heat dissipation assembly main body 220 to the upper housing 110, thereby improving the heat dissipation capability.

Specifically, as shown in FIGs. 1, 2 and 5, the upper housing 110 in the embodiments of the present application is provided with a thermal conductive adhesive groove 115, the thermal conductive adhesive layer 700 may be filled into the thermal conductive adhesive groove 115, and the thermal conductive adhesive layer 700 is in contact with the heat dissipation assembly main body 220 after the assembly of the housing, so that the heat of the heat dissipation assembly main body 220 is exported to the upper housing 110.

Optionally, the thermal conductive adhesive layer 700 in the embodiments of the present application may be located on a side of the elastic member 400 facing the heat dissipation fin 230, to facilitate the insertion of an adhesive gun into the upper housing 110 and allow the adhesive to be injected into the thermal conductive adhesive groove 115, thereby preventing the adhesive gun from interfering with other components.

As shown in FIG. 1, the heat dissipation assembly 200 in the embodiments of the present application further includes a fan 240. The fan 240 is provided on a side of the heat dissipation fin 230 facing away from the circuit board 300, for example, in the heat dissipation through hole 113 inside the upper housing 110. The fan 240 is configured to export the heat of the heat dissipation fins 230 to the external environment, thereby improving the heat conduction speed and improving the heat dissipation capability.

A side of the fan 240 facing away from the circuit board 300 is further connected to a fan cover 250, and the fan 240, the fan cover 250 and the upper housing 110 are connected through a second fastener 800, thereby forming a whole structure.

Specifically, as shown in FIGs. 1 and 4, the upper housing 110 in the embodiments of the present application is further provided with a plurality of fan fixing structures 116. The fan fixing structure 116 may include a threaded hole or a guiding post. A corresponding through hole is provided on the fan cover 250. The second fastener 800 passes through the through hole and then is fixed in the threaded hole, to connect the fan 240, the fan cover 250 and the upper housing 110 as a whole.

An embodiment of the present application further provides a mobile platform including the above-mentioned domain controller.

Specifically, the mobile platform in the embodiments of the present application may be, for example, a vehicle, and the domain controller is provided inside the vehicle to manage and control various functions of the vehicle by processing data information. Due to the use of the above-mentioned domain controller, it is possible to ensure that the chips have good heat dissipation while reducing the stress on the chips and the circuit board, thereby reducing the risk of chip cracking.

In the description of the present application, it should be understood that the orientation or positional relationships indicated by the terms "center", "longitudinal", "lateral", "length", "width", "thickness", "up", "down", "front", "rear", "left", "right", "vertical", "horizontal", "top", "bottom", "inside", "outside", "clockwise", "counterclockwise", "axial", "radial", "circumferential", etc. are based on the orientation or positional relationships shown in the accompanying drawings, which are only for the convenience of describing the present application and simplifying the description, rather than indicating or implying that the indicated device or element must have a particular orientation, be constructed and operated in a particular orientation, and thus cannot be understood as limitations of the present application.

In the present application, unless otherwise specified or defined, the terms "mount", "connect", "couple" and "fix" should be understood in a broad sense, for example, it may be fixed connection, detachable connection, or integrated; or it may be direct connection or indirect connection through an intermediate medium; or it may be inner communication of two elements or interaction relationships of the two elements. For those ordinarily skilled in the art, the specific meanings of the above terms in the present application can be understood based on specific circumstances.

It should be noted that, in the description of the present application, the terms "first" and "second" are only used to facilitate the description of different components, and cannot be understood as indicating or implying a sequential relationship, a relative importance or implicitly indicating the quantity of the indicated technical features. Therefore, the features defined by "first" and "second" may explicitly or implicitly include at least one of such features.

The embodiments or implementations in the present application are described in a progressive manner, with each embodiment emphasizing its differences from other embodiments. The same and similar parts between the embodiments can be referred to each other.

In the description of the present application, the description referring to the terms "an embodiment", "some embodiments", "an exemplary embodiment", "an example", "a specific example", or "some examples" means that the specific features, structures, materials, or characteristics described in conjunction with the embodiment or example are included in at least one embodiment or example of the present application. In the present application, the schematic expressions of the above terms do not necessarily refer to the same embodiment or example. Furthermore, the above-described specific features, structures, materials, or characteristics may be combined in an appropriate manner in any one or more embodiments or examples.

Finally, it should be noted that the foregoing embodiments are merely intended for describing the technical solutions of the present application rather than limiting the present application. Although the present application is described in detail with reference to the foregoing embodiments, those ordinarily skilled in the art should understand that they may still make modifications to the technical solutions described in the foregoing embodiments, or make equivalent replacements to some or all technical features thereof, and these modifications or replacements do not make the essence of the corresponding technical solutions depart from the scope of the technical solutions of the various embodiments of the present application.

## Claims

1. A domain controller, comprising a housing, wherein a heat dissipation assembly (200) and a circuit board (300) are stacked in the housing, a side of the circuit board (300) facing the heat dissipation assembly (200) is provided with a first chip (310), the heat dissipation assembly (200) is provided with a first heat dissipation boss (211), a side of the heat dissipation assembly (200) facing away from the circuit board (300) is further provided with an elastic member (400) in a compressed state, wherein a first end of the elastic member (400) abuts against the housing and a second end of the elastic member (400) abuts against the heat dissipation assembly (200), enabling the first heat dissipation boss (211) to abut against the first chip (310), and the housing is provided with a supporting portion (121) and the supporting portion (121) abuts against the circuit board (200).

2. The domain controller according to claim 1, wherein the elastic member (400) comprises a spring, the housing is provided with a mounting groove (111), and the spring is provided in the mounting groove (111).

3. The domain controller according to claim 1 or 2, wherein the elastic member (400) comprises a sealing ring or a resilient pad, and the elastic member (400) is provided along a circumferential direction of the heat dissipation assembly (200).

4. The domain controller according to any one of claims 1 to 3, wherein the housing comprises a bottom cover (120) and an upper housing (110), the circuit board (200) is provided close to the bottom cover (120), the supporting portion (121) is provided on the bottom cover (120), and the bottom cover (120), the upper housing (110) and the circuit board (200) are connected through a first fastener (500), to compress the elastic member (400) between the upper housing (110) and the heat dissipation assembly (200).

5. The domain controller according to claim 4, wherein in a plane parallel to the circuit board (200), a projection of the first chip (310) is located within a projection range of the supporting portion (121).

6. The domain controller according to claim 4 or 5, wherein the side of the circuit board (200) facing the heat dissipation assembly (200) is further provided with a plurality of second chips (320), the plurality of second chips (320) are provided around the first chip (310), the heat dissipation assembly (200) is further provided with a plurality of second heat dissipation bosses (212), and the plurality of second heat dissipation bosses (212) are in one-to-one correspondence with the plurality of second chips (320).

7. The domain controller according to claim 6, wherein a first thermal conductive layer (610) is filled between the first heat dissipation boss (211) and the first chip (310), a second thermal conductive layer (620) is filled between the second heat dissipation boss (212) and the second chip (310), and a thickness of the second thermal conductive layer (620) is greater than a thickness of the first thermal conductive layer (610).

8. The domain controller according to claim 6 or 7, wherein the heat dissipation assembly (200) comprises a vapor chamber (210) and a heat dissipation assembly main body (220), wherein the vapor chamber (210) is provided on a side of the heat dissipation assembly main body (220) facing the circuit board (200), and the first heat dissipation boss (211) and the plurality of second heat dissipation bosses (212) are all provided on the vapor chamber (210).

9. The domain controller according to claim 8, wherein the heat dissipation assembly main body (220) is provided with a plurality of limiting holes (221), the upper housing (110) is provided with a plurality of limiting posts (112), the plurality of limiting posts (112) are in one-to-one correspondence with the plurality of limiting holes (221), and the limiting posts (112) are inserted into the corresponding limiting holes (221).

10. A mobile platform, comprising the domain controller according to any one of claims 1 to 9.
